(19) Europäisches Patentamt / European Patent Office / Office européen des brevets

(11) **EP 2 950 446 B1**

(12) **EUROPÄISCHE PATENTSCHRIFT**

(45) Veröffentlichungstag und Bekanntmachung des Hinweises auf die Patenterteilung:
**08.08.2018 Patentblatt 2018/32**

(51) Int Cl.:
***H02S 50/10*** *(2014.01)*

(21) Anmeldenummer: **15168785.2**

(22) Anmeldetag: **22.05.2015**

(54) **VERFAHREN ZUM ERKENNEN DES VERSCHMUTZUNGSGRADS VON PV-MODULEN**

METHOD FOR DETECTING THE CONTAMINATION LEVEL OF PV MODULES

PROCÉDÉ DE DÉTECTION D'UN DEGRÉ DE SALISSURE DE PANNEAUX PV

(84) Benannte Vertragsstaaten:
**AL AT BE BG CH CY CZ DE DK EE ES FI FR GB GR HR HU IE IS IT LI LT LU LV MC MK MT NL NO PL PT RO RS SE SI SK SM TR**

(30) Priorität: **27.05.2014 DE 102014107417**

(43) Veröffentlichungstag der Anmeldung:
**02.12.2015 Patentblatt 2015/49**

(73) Patentinhaber: **skytron energy GmbH**
**10245 Berlin (DE)**

(72) Erfinder:
• **Hoffmann, Hendrik**
**15738 Zeuthen (DE)**
• **Batista, Agustin Javier Carretero**
**10551 Berlin (DE)**

(74) Vertreter: **Hertin und Partner**
**Rechts- und Patentanwälte PartG mbB**
**Kurfürstendamm 54/55**
**10707 Berlin (DE)**

(56) Entgegenhaltungen:
EP-A1- 2 077 453      WO-A1-2013/065053
WO-A1-2013/093152     DE-A1-102011 082 854
US-A1- 2008 272 279

**Beschreibung**

Die Erfindung betrifft ein Verfahren zum Erkennen des Verschmutzungsgrads von PV-Modulen.

Die Verschmutzung von PV-Modulen verringert den Wirkungsgrad und damit die bei gegebener solarer Einstrahlung zu erzielende elektrische Leistung. Daher kann es von Interesse sein, die photovoltaischen Module zu reinigen oder die Verschmutzung für Prognosen der PV-Anlage zu berücksichtigen. Für beide Fälle ist es hilfreich, den Verschmutzungsgrad zu kennen.

Die US 2008/272279 A1 betrifft ein Verfahren und eine Vorrichtung zur Anzeige des Zustandes eines Solarpanels. Dabei werden bei dem Verfahren Betriebszustandssignale des Solarpanels ausgewertet, die insbesondere ein Beleuchtungs- und ein Alterungssignal umfassen. Des Weiteren wird ein Leistungssignal vom Solarpanel, welches die tatsächliche abgegebene Leistung des Solarpanels angibt, verwendet, um eine Leistungsschätzung als Antwort auf die Betriebszustandssignale zu ermitteln. Diese Leistungsschätzung stellt die erwartete, abzugebende Leistung des Solarpanels dar. Es wird darüber hinaus durch das Verfahren ein Warnsignal bereitgestellt, welches von einer Differenz zwischen dem Leistungssignal und der Leistungsschätzung abhängig ist.

Der Erfindung liegt die Aufgabe zu Grunde, die Erkennung des Verschmutzungsgrads von PV-Modulen zu verbessern.

Diese Aufgabe wird mit den Merkmalen des Anspruchs 1 gelöst. Vorteilhafte Weiterbildungen der Erfindung sind in den abhängigen Ansprüchen definiert.

Gemäß der Erfindung umfasst ein Verfahren zum Erkennen des Verschmutzungsgrads von PV-Modulen eines Strangs die folgenden Schritte:

- Bestimmen der Abweichungen der Strang-Leistungswerte von einem berechneten Referenzwert über das letzte Jahr;
- Berechnen einer historischen Trendlinie aus den Abweichungen;
- Ermitteln einer maximalen Differenz zwischen der Trendlinie und den Abweichungen;
- Berechnen von finalen Abweichungen der Leistungswerte durch Subtraktion der maximalen Differenz von der Trendlinie; und
- Ermitteln des Verschmutzungsgrads durch Subtraktion der finalen Abweichungen von den Abweichungen.

Das erfindungsgemäße Verfahren basiert auf der Bestimmung der Abweichungen der Strang-Leistungswerte von einem berechneten Referenzwert bzw. berechneten Referenzwerten. Da die PV-Module beziehungsweise deren Strangleistungen direkt verwendet werden und keine zusätzlichen Messgeräte ist das Verfahren sehr genau und unabhängig von Modul- oder Sensortechnologien. Zudem sind die Strang-Monitoring-Daten einfach, genau und in hoher zeitlicher Auflösung verfügbar. Mit dem ermittelten Verschmutzungsgrad lassen sich Reinigungszyklen festlegen, was insbesondere in Gebieten mit Wasserknappheit von Vorteil ist, da sich so das für die Reinigung benötigte Wasser auf ein Minimum beschränken lässt.

Das Verfahren kann auf Tageswerten basieren. Dies bedeutet, dass die Ermittlung der Verschmutzungsrate eine Auflösung von einem Tag hat. Die zugrundeliegenden Messwerte wie zum Beispiel die Strangleistung kann eine geringere Auflösung, beispielsweise eine Minute haben. Die Auflösung von einem Tag ist ausreichend und erlaubt eine Bestimmung der Verschmutzungsrate nach einem abgelaufenen Tag oder nach Sonnenuntergang, wenn keine weiteren Messwerte mehr verarbeitet werden müssen.

Ein Einstrahlungssensor kann zur Berechnung der Strang-Leistungswerte verwendet werden. Mit dem Sensor kann die Leistungsberechnung und/oder die Berechnung des Referenzwerts abgeglichen werden, was die Zuverlässigkeit des Verfahrens erhöht.

Ein zeitlicher Versatz der Strang-Leistungswerte durch Ausrichtungsfehler des Einstrahlungssensors kann ermittelt und berücksichtigt werden. Diese Kalibrierung erhöht die Genauigkeit des Verfahrens.

Messfehler durch Alterung des Einstrahlungssensors können durch vergleichen aller bisher beobachteten wolkenfreien Tagen ermittelt und berücksichtigt werden. Mit diesem Schritt kann die durch die Alterung entstehende Drift erkannt und kalibriert werden, so dass keine Verfälschung der Messergebnisse zu Stande kommt.

Strang-Leistungswerte können aus einem Zeitintervall von einer Stunde um den maximalen Höhenwinkel der Sonne verwendet werden. In diesem Zeitintervall sind die Werte aufgrund der hohen Einstrahlung stabil und zuverlässig.

Die Strang-Leistungswerte können verworfen werden, wenn eine Ausgangsleistung eines Inverters des Strangs einen Grenzwert überschreitet, wobei der Grenzwert größer 95 Prozent und kleiner 100 Prozent einer Nenn-Ausgangsleistung des Inverters ist. Damit wird ein sogenanntes Inverter-Clipping ausgeschlossen, bei dem der Inverter über oder am Rande seiner Nennleistung betrieben wird, was zu unstabilen und damit für das verfahren ungenauen Betriebszuständen führen kann. Das Verwerfen kann derart realisiert sein, dass dieser Tag nicht für die Ermittlung der Modulverschmutzung betrachtet wird.

Die Strang-Leistungswerte können verworfen werden, wenn eine durchschnittliche gemessene Einstrahlung um einen Grenzwert von einer simulierten Einstrahlung abweicht, wobei der Grenzwert zwischen 5 Prozent und 25 Prozent liegt. Hier werden Tage herausgefiltert, an denen die solare Einstrahlung für ein sicheres und genaues Verfahren nicht ausreichend hoch ist.

Die Strang-Leistungswerte können verworfen werden, wenn eine Abweichung zwischen zwei zeitlich aufeinander folgenden Messwerten der Einstrahlung einen Grenzwert überschreitet, wobei der Grenzwert zwischen 100 Watt pro qm und 300 W pro qm liegt. Hier werden Tage herausgefiltert, an denen die solare Einstrahlung für ein sicheres und genaues Verfahren nicht ausreichend stabil ist.

Die Strang-Leistungswerte können verworfen werden, wenn eine Ausgangsleistung eines Inverters des Strangs zum Beispiel durch einen Defekt oder eine Abregelung begrenzt wurde. In diesen Fällen ist die Genauigkeit verringert, so dass diese Werte oder die Zeiträume für diese Werte nicht verwendet werden.

Die gesamte Betriebszeit der PV-Module kann betrachtet werden, das heißt ab der Inbetriebnahme bis zum aktuellen Zeitpunkt. Dies hat den Vorteil, dass das Verfahren aufgrund der verbesserten Datenlage genauer wird.

Der Verschmutzungsgrad mindestens eines Strangs kann ermittelt werden. Im Bezug auf die PV-Anlage, also das regenerative Kraftwerk, können so bestimmte Teile, basierend auf einzelnen Strängen, oder das gesamte Kraftwerk, basierend auf allen Strängen, betrachtet werden.

Im Folgenden wird die Erfindung anhand der Zeichnungen näher beschrieben, es zeigen:

Figur 1 eine schematische Darstellung eines PV Kraftwerks.

Figur 2 ein Diagramm zur Ermittlung eines zeitlichen Versatzes der Strang-Leistungswerte durch Ausrichtungsfehler eines Einstrahlungssensors.

Figur 3 ein Diagramm einer zeitlichen Darstellung des Verfahrens.

Figur 4 ein Diagramm darstellend ein Inverter-Clipping.

Figur 5 ein Diagramm einer solaren Einstrahlung eines Tages.

Figur 6 ein Diagramm zur Darstellung von hoher und stabiler Einstrahlung.

Figur 7 ein Diagramm darstellend eine Temperaturnormalisierung der Leistung.

Figur 8 ein Diagramm darstellend eine Einstrahlungsnormalisierung der Leistung.

Figur 9 ein Diagramm darstellend die Berechnung der Leistungsabweichung.

Figur 10 ein Diagramm der historischen Abweichung der Strang-Leistung.

Figur 11 ein Diagramm der historischen Abweichung der Strang-Leistung nach einer ersten Filterung.

Figur 12 ein Diagramm der historischen Abweichung der Strang-Leistung nach einer zweiten Filterung.

Figur 13 ein Diagramm der historischen Abweichung der Strang-Leistung mit einem Letzt-Jahres-Mittel.

Figur 14 ein Diagramm des Letzt-Jahres-Mittels der Abweichung der Strang-Leistung mit einer Trendlinie.

Figur 15 ein Diagramm der Moduldegradation und der Rate der Modulverschmutzung.

Die Zeichnungen dienen lediglich der Erläuterung der Erfindung und schränken diese nicht ein. Die Zeichnungen und die einzelnen Teile sind nicht notwendigerweise maßstäblich. Gleiche Bezugszeichen bezeichnen gleiche oder ähnliche Teile.

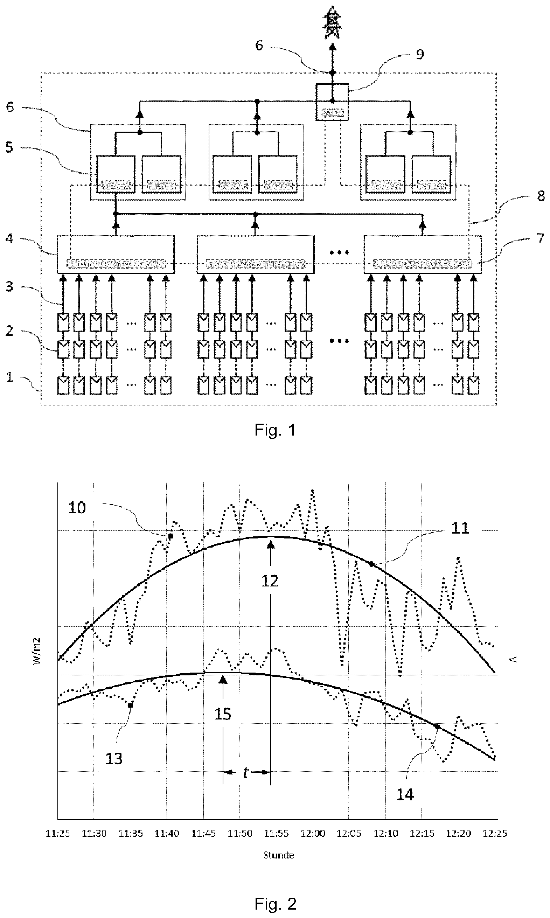

Figur 1 zeigt ein Photovoltaik-Kraftwerk 1 mit mehreren Solarmodulen 2. Die Solarmodule 2 sind in Strängen oder Strings 3 angeordnet. Dazu sind mehrere Solarmodule 2 hintereinander geschaltet. Mehrere Stränge 3 können logisch und/oder schaltungstechnisch zu Zonen zusammengefasst sein.

Jeder Strang 3 führt zu einem Generatoranschlusskasten 4 oder einem ähnlichen Anschlusspunkt für den Strang 3. Hier ist jedem Generatoranschlusskasten 4 ein Strang 3 zugeordnet, es können auch mehrere Stränge 3 an einem Generatoranschlusskasten 4 angeschlossen sein. Der Generatoranschlusskasten 4 muss keine eigenständige Einheit sein, sondern kann auch Bestandteil, wie zum Beispiel eine Platine, Baueinheit oder Softwareroutine für die Signalverarbeitung, einer anderen elektrischen und/oder elektronischen Einheit sein.

Die Generatoranschlusskästen 4 sind mit Wechselrichtern oder Stromrichtern 5 verbunden. Die Wechselrichter 5 richten den von den Solarmodulen 2 erzeugten Gleichstrom in Wechselstrom um. Hier sind zwei Generatoranschlusskästen 4 mit einem Wechselrichter 5 verbunden. Dieses Verhältnis kann je nach Anlage, verwendeten Komponenten usw. anders gewählt werden.

Die Wechselrichter 5 sind zu einem Kraftwerksblock 6 zusammengefasst und/oder sind an einen Netzübergabepunkt 6 angeschlossen. Der Netzübergabepunkt 6 ist ausgangsseitig mit dem Stromnetz oder Grid verbunden.

Die oben erläuterten Verbindungen zwischen den Solarmodulen 2, den Generatoranschlusskästen 4, den Wechselrichtern 5 und/oder dem Netzübergabepunkt 6 sind in erster Linie Verbindungen zur Übertragung von Energie. Darüber hinaus können über diese Verbindungen und/oder weitere Verbindungen Informationen übertragen werden. Diese Informationen können explizite Informationen wie zum Beispiel Steuerdaten, Betriebsdaten usw. oder implizite Informationen sein, die in der Energieübertragung enthalten sind und extrahiert werden.

Eine Steuer- oder Recheneinheit 7 nimmt Messwerte der Messkanäle 3 auf. Die Messwerte werden der Steuereinheit 7 über Signalleitungen 8 zugeführt. In Figur 1 sind mehrere Signalleitungen zu den Solarmodulen 2, den Generatoranschlusskästen 4, den Wechselrichtern 5 und dem Netzübergabepunkt 6 gezeigt. Weitere Signalleitungen zu den anderen Solarmodulen 2, den Generatoranschlusskästen 4 und dem Wechselrichter 5 sind aus Gründen der Übersichtlichkeit nicht dargestellt. Es kann auch lediglich ein einzelner Typ von Signalleitungen 8 zum Beispiel zu den Generatoranschlusskästen 4 verwendet werden.

Strang-Leistungswerte der einzelnen Stränge werden in den Generatoranschlusskästen 4 und/oder den Wechselrichtern 5 erfasst. Die Strang-Leistungswerte charakterisieren die pro Strang erzeugte elektrische Leistung, insbesondere die Wirkleistung. Die Strang-Leistungswerte werden regelmäßig gemessen, zum Beispiel in einem Takt von einer Minute oder von wenigen Minuten wie zum Beispiel fünf oder zehn Minuten.

Die Steuereinheit 7 verarbeitet bzw. validiert die Messwerte in Abhängigkeit vom Sonnenstand. Eine Kraftwerkssteuerung oder -regelung 9, welche Betriebsabläufe des Photovoltaik-Kraftwerks 1 überwacht und regelt steht in Verbindung mit der Steuereinheit 7, so dass Messwerte, Informationen, Ergebnisse und weitere Daten ausgetauscht werden können. Die Steuereinheit 7 kann als Bestandteil der Kraftwerkssteuerung 9 in Hardware und/oder Software ausgeführt sein.

In der Steuereinheit 7 und/oder der Kraftwerkssteuerung 9 wird das nachfolgend beschriebene Verfahren zum Erkennen des Verschmutzungsgrads von PV-Modulen 2 eines Strangs 3 ausgeführt. Das Verfahren kann auch in einer anderen Einheit ausgeführt, die zum Beispiel von dem Photovoltaik-Kraftwerk 1 räumlich getrennt ist. Die Messwerte werden dann über drahtgebundene und/oder drahtlose Verbindungen von dem Photovoltaik-Kraftwerk 1 zu der Einheit übertragen.

Im Folgenden wird das Verfahren zum Erkennen des Verschmutzungsgrads von PV-Modulen 2 eines Strangs 3 näher beschrieben.

Das Verfahren basiert auf der Berechnung oder Bestimmung der Abweichungen der Strang-Leistungswerte von einem berechneten Referenzwert bzw. berechneten Referenzwerten. Die gemessene Strang-Leistung beruht auf akkuraten Strom- und Spannungsmessungen, die jede Minute ausgeführt werden. Die Normalisierung der standardisierten STC Leistung auf die gemessenen Wetterbedingungen wird für die berechneten oder simulierten Referenzwerte verwendet. Daten oder Messwerte des Einstrahlungssensors werden vor der Verwendung validiert oder kompensiert. Dies kann eine Kompensation einer Fehlausrichtung und/oder Abweichungen durch Alterung umfassen. Die Berechnung der endgültigen Verschmutzungsrate wird nur bei geeigneten Umweltbedingungen innerhalb der Betriebsgrenzen des Inverter MPP Betriebs durchgeführt. Dann wird ein präziser Zeit-Filter-Algorithmus angewandt, um innerhalb ausgewählter klarer Tage das optimale Zeitfenster für die Berechnung zu positionieren.

Zunächst wird ein zeitlicher Versatz der Strang-Leistungswerte durch Ausrichtungsfehler eines Einstrahlungssensors ermittelt. Dies wird anhand von Figur 2 beschrieben. Figur 2 ist eine kombinierte Darstellung der Einstrahlung in W/m$^2$ und des Strangstroms in A aufgetragen über einen Zeitraum von einer Stunde in der Mittagszeit.

Aus einer Kurve der Einstrahlung 10 wird ein Näherungspolynom 11 mit einer maximalen Einstrahlung 12 um etwa 11:54 Uhr berechnet. Aus einer Kurve des Strangstroms 13 wird ein Näherungspolynom 14 mit einem maximalen Strom 15 um etwa 11:47 Uhr berechnet. Die beiden Maxima sind um eine Zeitspanne t, die hier sieben Minuten beträgt voneinander versetzt. Diese Zeitspanne oder Dauer beruht auf einer horizontalen Fehlausrichtung des Sensors.

Folgende Formel beschreibt die Zeitverzögerung:

$$Delay_{SENSOR}\,[minutes] = Time_{MAX.\ RADIATION} - Time_{MAX.\ STRING\ CURRENT}$$

Wobei Delay$_{Sensor}$ die Zeitverzögerung ist, Time$_{Max.\ Radiation}$ der Zeitpunkt der maximalen Einstrahlung und Time$_{Max.\ String\ Current}$ der Zeitpunkt des maximalen Strang-Stroms ist.

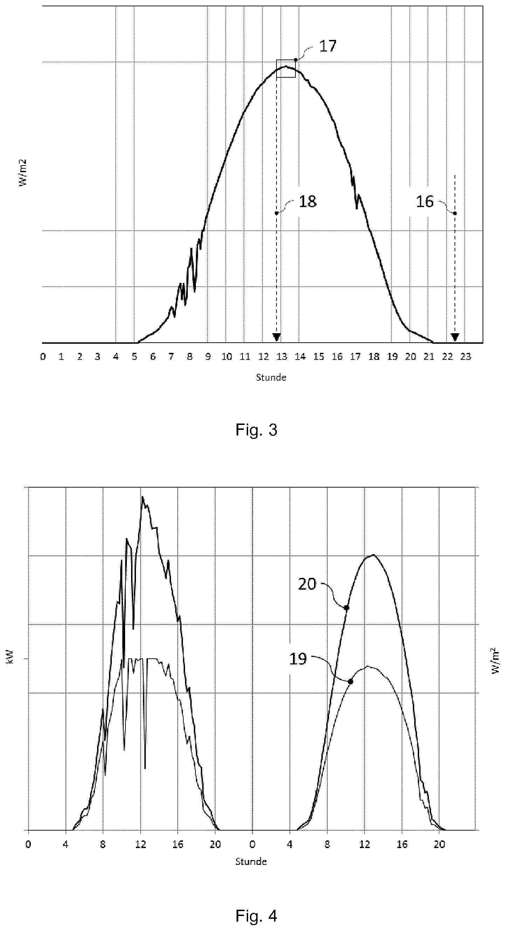

Figur 3 zeigt den zeitlichen Ablauf des Verfahrens. Aufgetragen ist die Einstrahlung in W/m² über den Tag, das heißt von Null bis vierundzwanzig Stunden. Jeden Tag nach Sonnenuntergang wird überprüft, ob dieser Tag den im Folgenden beschriebenen Bedingungen genügt, um ihn für die Berechnung der Abweichung der Strang-Leistung beziehungsweise der Strang-Leistungswerte zu verwenden.

Die Überprüfung findet zu einem Zeitpunkt 16 statt, der hier 22:30 Uhr der lokalen Zeit des Kraftwerks 1 entspricht. Dies entspricht folgender Formel.

$$Checking\ Time_{CLEAR-SKY\ DAY} = 22:30:00\ (Local\ Time)$$

Wobei Checking Time$_{Clear-Sky\ Day}$ dem Überprüfungszeitpunkt für einen Tag mit klarem Himmel entspricht.

Ferner ist aus Figur 2 ein Zeitintervall 17 von beispielsweise einer Stunde um den maximalen Höhenwinkel der Sonne zur Erfassung und/oder Berücksichtigung der Messwerte ersichtlich. In diesem Intervall 17 herrschen optimale Einstrahlungsbedingungen. Die Startzeit 18 für das Zeitfenster oder Intervall 17 berechnet sich anhand folgender Formel, welche die zuvor ermittelte Zeitverzögerung des Sensors berücksichtigt.

$$Time_{NTW}^{start} = Time_{SOLAR\ NOON} + Delay_{SENSOR} - 30\ minutes$$

Wobei Time$_{start\ NTW}$ dem Startzeitpunkt 18 des Intervalls 17 entspricht und Time$_{Solar\ Noon}$ dem maximalen Höhenwinkel der Sonne entspricht.

Der überprüfte oder zu überprüfende Tag wird verworfen, wenn das Kraftwerk 1 beziehungsweise dessen Ausgangsleistung abgeregelt wurde oder Komponenten des Kraftwerks 1 defekt sind. Nur wenn die Ausgangsleistung des Inverters 5 oder der Inverter oder des Kraftwerks 1 über einem Leistungs-Grenzwert liegen, der eine Größe von beispielsweis über 90% hat. Der Leistungs-Grenzwert soll möglichst nah an dem maximal möglichen Wert liegen.

Der überprüfte Tag wird auch verworfen, wenn der Inverter 5 des Strangs 3 sich seiner nominalen Ausgangsleistung annähert. Dies führt dazu, dass eine Ausgangsleistung eines Inverters 5 des Strangs 3 einen Grenzwert überschreitet, woraufhin die Strang-Leistungswerte dieses Strangs 3 oder sämtliche Messwerte des Kraftwerks 1 verworfen werden. Der Grenzwert soll vorzugsweise kleiner als 100 Prozent einer Nenn-Ausgangsleistung des Inverters 5 sein. Vorzugsweise ist der Grenzwert größer 95 als Prozent und kleiner als 100 Prozent einer Nenn-Ausgangsleistung des Inverters 5. Folgende Formel beschreibt dieses Kriterium.

$$Power_{inverter} < Power_{inverter}^{nominal} * x$$

Wobei Power$_{Inverter}$ die Ausgangsleistung des Inverters 5, Power$_{Nominal}$ Inverter die Nenn-Ausgangsleistung des Inverters 5 und x der Grenzwert ist.

Dieser Effekt, der als Inverter-Clipping bekannt ist, tritt auf, wenn die Module eine höhere Leistung als ihre angegebene standardisierte Leistung STC abgeben. Diese Leistung wird unter Normalbedingungen, beispielsweise für Einstrahlungen über 1000 W/m² und Modultemperaturen unter 25°C definiert.

In Figur 4 ist ein Beispiel gezeigt. Dort ist eine Einstrahlungskennlinie 19 in W/m² und eine Leistungskennlinie 20 des Inverters 5 in kW dargestellt. Links ist ein Tag mit Clipping oder Übersteuerung der Leistungskennlinie 20 anhand erhöhter Einstrahlung dargestellt. Der rechte Tag mit niedrigerer Einstrahlung zeigt eine glatte Leistungskennlinie 20. Der linke Tag wird verworfen, während der rechte Tag weiter untersucht wird.

In einem nächsten Schritt wird die direkte durchschnittliche gemessene Einstrahlung während eines klaren Tages bei dem maximalen Höhenwinkel der Sonne ($E_{t,max}$) simuliert. Dabei werden die Intensität der solaren Strahlung über der Erdatmosphäre ($E_S$), der geographischen Breite $\Phi$ des Kraftwerks 1, dem Neigungswinkel $\beta$ des Moduls 2, dem Neigungswinkel der Erde ($\delta$) und dem Stundenwinkel der Sonne ($\omega$) berücksichtigt. Folgende Formel beschreibt den Zusammenhang.

$$E_{t,max} = E_S * [\cos(\Phi - \beta) * \cos\delta * \cos\omega + \sin(\Phi - \beta) * \sin\delta]$$

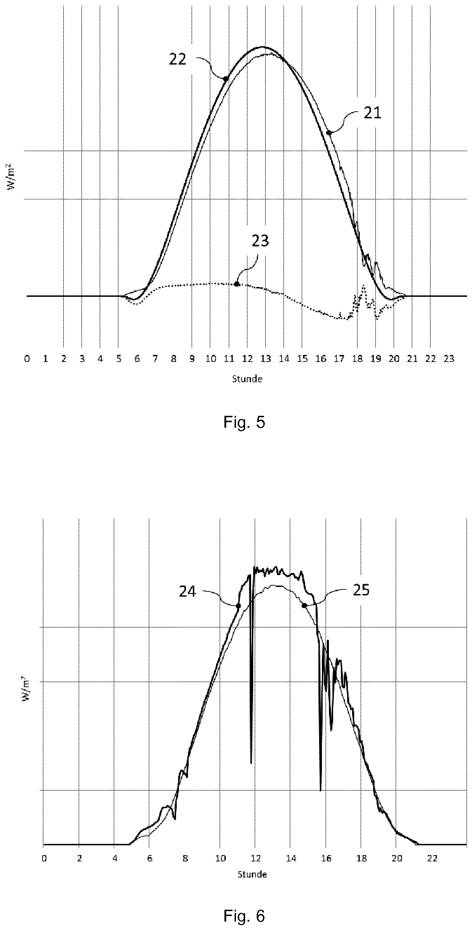

Figur 5 zeigt ein Beispiel einer Einstrahlung eines klaren Tages. Dort ist die Einstrahlung in W/m² über einen Tag aufgetragen. Die Kurve 21 stellt die durchschnittliche gemessene Einstrahlung einer Referenzzelle dar. Die Kurve 22 zeigt die simulierte Einstrahlung und die Kurve 23 gibt die Differenz zwischen Messwert und Simulation an.

Der Tag oder die Strang-Leistungswerte werden verworfen, wenn die durchschnittliche gemessene Einstrahlung um einen Grenzwert von der simulierten Einstrahlung abweicht, wobei der Grenzwert zwischen 5 Prozent und 25 Prozent liegt. Somit wird der überprüfte Tag verworfen, wenn die solare Einstrahlung nicht hoch genug ist.

Der Tag wird verworfen, wenn die solare Einstrahlung nicht stabil genug ist. Dies ist in Figur 6 dargestellt. Dort sind die Einstrahlungswerte zweier Tage gegen die Stunden des Tages aufgetragen. Die Kurve 24 eines bewölkten Tages zeigt einen unstetigen Verlauf, während die Kurve 25 eines klaren Tages einen stetigen Verlauf zeigt, der für eine weitere Berechnung gut geeignet ist.

Gemäß der Formel

$$\sum_{i=1}^{60} \left| G_i - G_{i-1} \right| < y \, W/m^2$$

soll die Summe von allen absoluten Differenzen zwischen der gemessenen solaren Einstrahlung $G_i$ in jeder Minute des Mittags-Zeitintervalls 17 und der davorliegenden Minute $G_{i-1}$ unter einem Grenzwert y liegen. Der Grenzwert y liegt zwischen 100 Watt pro qm und 300 W pro qm.

Wenn der überprüfte Tag nicht alle oder zumindest eine gewisse Auswahl der obigen Kriterien oder Bedingungen erfüllt, wird der Tag verworfen und eine Betrachtung eines nächsten Tages wird durchgeführt beziehungsweise die Suche nach einem klaren Tag wird weitergeführt. Als klarer Tage kann hier ein Tag bezeichnet werden, der alle oder zumindest eine gewisse Auswahl der obigen Kriterien erfüllt.

Erfüllt der Tag alle Kriterien wird eine Abweichung des Strang-Leistungswertes berechnet oder bestimmt. Diese Berechnung wird vorzugsweise jede Minute in dem Zeitintervall 17 ausgeführt.

Wenn der Inverter 5 sich nicht im MPP (Maximum Power Point) befindet, wird die entsprechende Minute verworfen. Der gemessene Strang-Strom soll gemäß der Formel

$$I_{string} > 1 \, A$$

mehr als 1 Ampere betragen.

Anschließend wird die Strang-Wirk-Leistung als Produkt des gemessenen Strang-Stroms und der gemessenen Strang-Spannung in der ersten Minute des Intervalls 17 gemäß folgender Formel berechnet.

$$P_{MPP,real} = I_{string} * V_{string}$$

Die nominelle Strang-Leistung $P_{STC}$ wird berechnet als das Produkt der Modul-STC-Leistung $P_{Module\ STC}$, der Anzahl der in Reihe geschalteten Module n und der Anzahl der parallel angeschlossenen Stränge in einem Messkanal p. Dies ist in der folgenden Formel angegeben.

$$P_{STC} = P_{STC}^{module} * n * p$$

Basierend auf der nominellen Strang-Leistung $P_{STC}$ wird die Strang-Leistung bei gemessener Modultemperatur $P_{Tmod\ STC}$ wie folgt berechnet.

$$P_{STC}^{T_{mod}} = P_{STC} * \left[ 1 + \gamma * \left( T_{mod} - 25°C \right) \right]$$

Wobei $T_{mod}$ die gemessene Modultemperatur und $\gamma$ der Temperaturkoeffizient der Modulleistung ist.

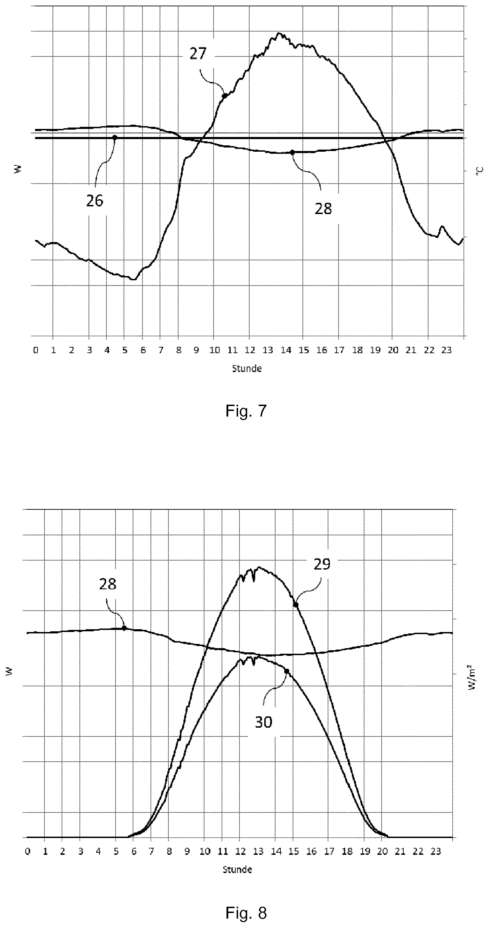

In Figur 7 sind die Kurven in Watt beziehungsweise °C gegenüber den Stunden des Tages aufgetragen. Die nominelle Strang-Leistung $P_{STC}$ ist als Kurve 26 und die gemessene Modultemperatur $T_{mod}$ ist als Kurve 27 dargestellt. Die temperaturnormalisierte Strang-Leistung $P_{Tmod\ STC}$ ist als Kurve 28 dargestellt.

Die gemessene Einstrahlung $G_t$ wird angepasst durch Kompensation mit der mittleren Abweichung des Sensors, die auf Alterung beruht. Eine berechnete oder simulierte Rate von 0,08335% pro Jahr wird angesetzt. Damit berechnet sich die kompensierte Einstrahlung $G_{t,comp}$ zu:

$$G_{t,comp} = G_t * (1 + 0.08335 * years)$$

Die Strangleistung unter der gemessenen Einstrahlung wird simuliert basierend auf der temperaturnormalisierten Strang-Leistung $P_{Tmod\ STC}$ und unter Betrachtung der kompensierten Einstrahlung $G_{t,comp}$. Gemäß folgender Formel ergibt sich die Strangleistung unter der gemessenen Einstrahlung $P_{MPP,sim}$ zu:

$$P_{MPP,sim} = P_{STC}^{T_{mod}} * \frac{G_{t,comp}}{1000\ W/m^2}$$

In Figur 8 sind die Leistungen in W und die Einstrahlung in W/m² gegen die Stunden des Tages aufgetragen. Die Kurve 28 zeigt wie in Figur 7 die temperaturnormalisierte Strang-Leistung $P_{Tmod\ STC}$ und die Kurve 29 die kompensierte Einstrahlung $G_{t,comp}$. Die daraus resultierende Strangleistung unter der gemessenen Einstrahlung $P_{MPP,sim}$ ist als Kurve 30 dargestellt.

In einem weiteren Schritt wird die Abweichung der Strang-Leistung Deviation_$P_{MPP}$ als das Verhältnis zwischen der Strang-Wirk-Leistung $P_{MPP,\ real}$ und der simulierten Strangleistung unter der gemessenen Einstrahlung $P_{MPP,sim}$ gemäß folgender Formel berechnet.

$$Deviation\_P_{MPP}\ [\%] = \left(1 - \frac{P_{MPP,real}}{P_{MPP,sim}}\right) * 100$$

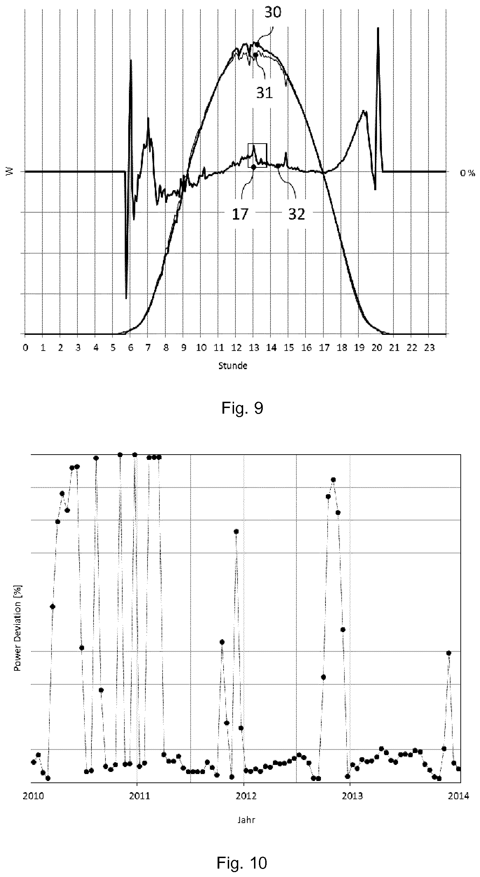

Die Ergebnisse sind in Figur 9 dargestellt, wobei die Strangleistung unter der gemessenen Einstrahlung $P_{MPP,sim}$ als Kurve 30 und die Strang-Wirk-Leistung $P_{MPP,real}$ als Kurve 31 dargestellt ist. Die Abweichung der Strang-Leistung Deviation_$P_{MPP}$ ist in Prozent als Kurve 32 dargestellt.

Die mittlere Abweichung der Strang-Leistungswerte Deviation_$P_{MPP,mean}$ innerhalb des Intervalls 17 wird berechnet unter Berücksichtigung der Anzahl der Minuten n, in denen der Inverter 5 im MPP läuft. Folgende Formel bietet die Berechnungsgrundlage.

$$Deviation\_P_{MPP,mean}[\%] = \frac{\sum_{i=1}^{n} Deviation\_P_{MPP,\ i}}{n}$$

Für jeden akzeptierten Tag wird eine mittlere Abweichung des Strang-Leistungswertes Deviation_$P_{MPP,mean}$ berechnet und über die Zeit gemeinsam mit allen vergangenen Werten wie in Figur 10 dargestellt aufgetragen. Es ist ersichtlich, dass einige sehr hohe Werte oder Ausreißer vorhanden sind. Diese Werte beruhen auf Schnee-Bedingungen oder anderen Störungen und sollen vor der weiteren Berechnung herausgefiltert werden.

Hier werden alle Werte, die um einen Grenzwert z in Prozent über dem Nullwert liegen ausgefiltert. Lediglich niedrigere Werte werden berücksichtigt. Die Formel für diesen Schritt lautet:

$$Deviation\_P_{MPP,mean} < y$$

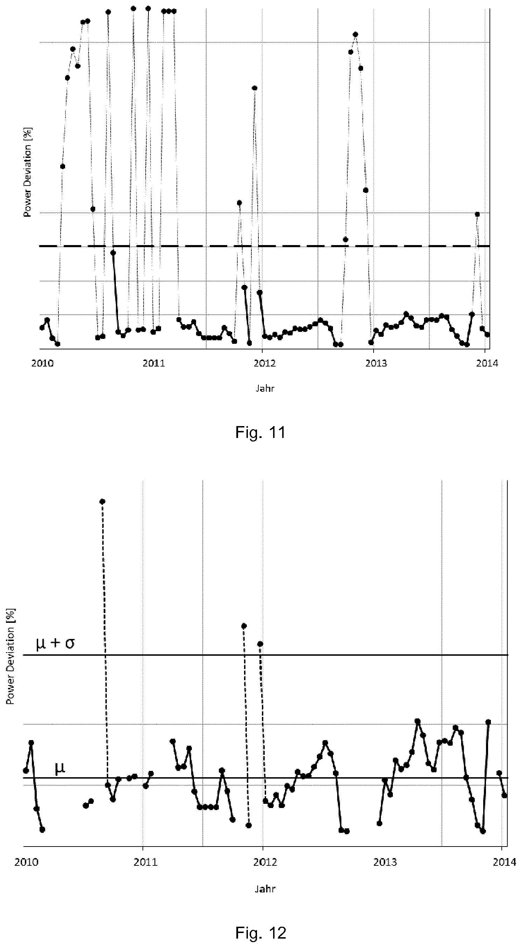

Der Wert von y kann den Bedingungen des Kraftwerks, der Messwerte und/oder der gewünschten Auflösung oder Genauigkeit eingestellt werden. Vorzugsweise liegt der Wert von y zwischen 20 und 50 Prozent. Das Ergebnis dieser Filterung ist in Figur 11 dargestellt.

Von den gefilterten Werten wird gemäß den folgenden Formeln die mittlere Abweichung $\mu$ und die Standard-Abweichung $\sigma$ unter Berücksichtigung der verbleibenden klaren Tage n berechnet.

$$\mu = \frac{\sum_{i=1}^{n} Deviation\_P_{MPP,mean,i}}{n}$$

$$\sigma = \sqrt{\frac{\sum_{i=1}^{n} \left(Deviation\_P_{MPP,mean,i}\right)^2}{n}}$$

Nun werden alle Werte oberhalb oder größer als die Standardabweichung plus der mittleren Abweichung gemäß folgender Formel verworfen.

$$Deviation\_P_{MPP,mean} < \mu + \sigma$$

Wie in Figur 12 dargestellt werden lediglich die niedrigeren Werte übernommen.

Aus den verbleibenden Werten wird eine neue Abweichungskurve berechnet. Für jeden verbleibenden klaren Tag wird das Mittel der vergangenen Werte nur für das letzte Jahr unter Berücksichtigung der verbleibenden klaren Tage n innerhalb dieses Zeitraums berechnet.

$$Deviation\_P_{LAST\ YEAR}[\%] = \frac{\sum_{i=1}^{n} Deviation\_P_{MPP,mean,i}}{n}$$

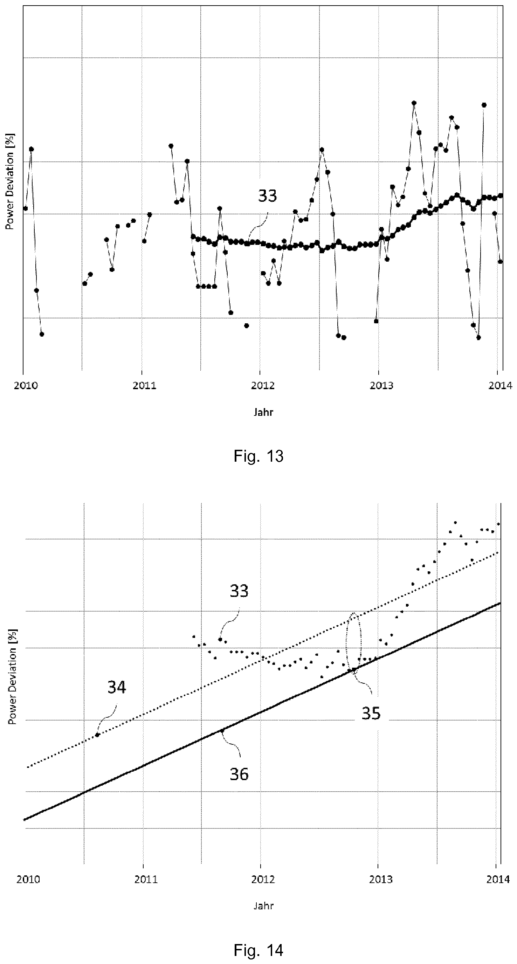

In Figur 13 ist die neue Abweichungskurve Deviation\_P$_{LAST\ YEAR}$ als Kurve 33 dargestellt. Aus Figur 13 ist ein ansteigender Trend für diese Kurve zu erkennen.

Eine historische Trendlinie *Deviation\_P$_{TREND\ LINE}$* 34 wird aus allen durchschnittlichen Abweichungswerten 33 des letzten Jahres berechnet. Diese Trendlinie 34 ist in Figur 14 dargestellt.

Eine maximale Differenz 35 zwischen der Trendlinie 34 und den Abweichungen 33 wird berechnet durch Vergleich für jeden Wert der Trendlinie 34 mit dem entsprechenden Abweichungswert 33. Die dabei ermittelte maximale Differenz Difference$_{Max}$ ergibt sich aus folgender Formel:

$$Difference = Deviation\_P_{TREND\ LINE} - Deviation\_P_{LAST\ YEAR}$$

Anschließend wird die Abweichung der Modulleistung Deviation\_P$_{Module}$ 36 berechnet durch Subtraktion der maximalen Differenz Difference$_{Max}$ 35 von der historischen Trendlinie *Deviation\_P$_{TREND\ LINE}$* 34. Die folgende Formel beschreibt dies.

$$Deviation\_P_{MODULE} = Deviation\_P_{TREND\ LINE} - Difference_{MAX}$$

Die Kurven sind in Figur 14 dargestellt.

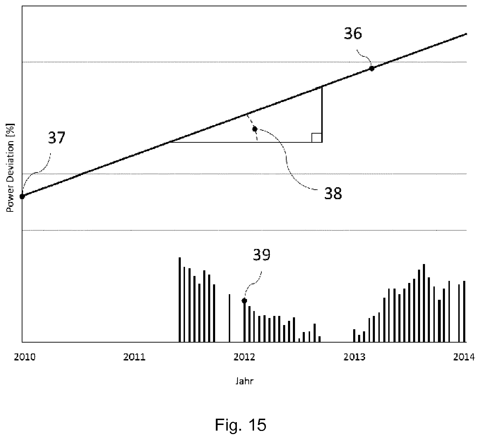

Wie in Figur 15 dargestellt wird die ursprüngliche Moduldegradation 37 aus der Abweichung der Modulleistung Deviation\_P$_{Module}$ 36 und dem Zeitpunkt der Inbetriebnahme des Kraftwerks 1 ermittelt. Dies geschieht gemäß folgender Formel.

$$D_{INITIAL}[\%] = Deviation\_P_{MODULE,\ Comm\_Date}$$

Aus der Steigung der Kurve 36 wird nun die Steigung ermittelt, was der jährlichen Moduldegradationsrate 38 entspricht. Die jährliche Moduldegradationsrate 38 kann berechnet werden zu:

$$D_{ANNUAL} [\%/a]$$
$$= \tan^{-1} \left( \frac{Deviation\_P_{MODULE,\,Today} - Deviation\_P_{MODULE,\,Comm\_Date}}{Today - Comm\_Date\,[years]} \right)$$

Schließlich wird der Verschmutzungsgrad 39 der Module durch Subtraktion der finalen Abweichungen beziehungsweise Abweichung der Modulleistung Deviation_$P_{Module}$ 36 von den Abweichungen beziehungsweise der Abweichungskurve Deviation_$P_{LAST\,YEAR}$ 33 ermittelt. Die folgende Formel definiert den Verschmutzungsgrad entsprechend.

$$Soling\,[\%] = Deviation\_P_{LAST\,YEAR} - Deviation\_P_{MODULE}$$

In Figur 15 ist der Verschmutzungsgrad 39 dargestellt. Der Verschmutzungsgrad 39 ist für jeden gültigen Tag aufgetragen. Anhand des oder der Verschmutzungsgrade kann zum Beispiel ein Reinigungszyklus für das Kraftwerk 1 definiert werden.

Einzelne Schritte des oben beschriebenen Verfahrens wie zum Beispiel die Sensornormierung sind optional. Auch die Reihenfolge der Schritte kann anders gewählt werden, wenn möglich können Schritte auch parallel durchgeführt werden oder ein Schritt implizit in einem anderen Schritt ausgeführt werden.

## Patentansprüche

1. Verfahren zum Erkennen des Verschmutzungsgrads von PV-Modulen (2) eines Strangs (3), mit den folgenden Schritten:

   - Bestimmen der Abweichungen (33) der Strang-Leistungswerte (31) von einem berechneten Referenzwert (30) über das letzte Jahr;
   - Berechnen einer historischen Trendlinie (34) aus den Abweichungen (33);
   - Ermitteln einer maximalen Differenz (35) zwischen der Trendlinie (34) und den Abweichungen (33);
   - Berechnen von finalen Abweichungen (36) der Leistungswerte durch Subtraktion der maximalen Differenz (35) von der Trendlinie (34); und
   - Ermitteln des Verschmutzungsgrads (39) durch Subtraktion der finalen Abweichungen von den Abweichungen.

2. Verfahren nach Anspruch 1, wobei das Verfahren auf Tageswerten basiert.

3. Verfahren nach Anspruch 1 oder 2, wobei ein Einstrahlungssensor zur Berechnung der Strang-Leistungswerte verwendet wird.

4. Verfahren nach Anspruch 3, wobei ein zeitlicher Versatz der Strang-Leistungswerte durch Ausrichtungsfehler des Einstrahlungssensors ermittelt und berücksichtigt wird.

5. Verfahren nach Anspruch 3 oder 4, wobei Messfehler durch Alterung des Einstrahlungssensors durch vergleichen aller bisher beobachteten wolkenfreien Tagen ermittelt und berücksichtigt wird.

6. Verfahren nach mindestens einem der Ansprüche 1 bis 5, wobei Strang-Leistungswerte aus einem Zeitintervall (17) um den maximalen Höhenwinkel der Sonne verwendet werden.

7. Verfahren nach mindestens einem der Ansprüche 1 bis 6, wobei die Strang-Leistungswerte verworfen werden, wenn eine Ausgangsleistung eines Inverters (5) des Strangs (3) einen Grenzwert überschreitet, wobei der Grenzwert größer 95 Prozent und kleiner 100 Prozent einer Nenn-Ausgangsleistung des Inverters (5) ist.

8. Verfahren nach mindestens einem der Ansprüche 1 bis 7, wobei die Strang-Leistungswerte verworfen werden, wenn eine durchschnittliche gemessene Einstrahlung um einen Grenzwert von einer simulierten Einstrahlung abweicht, wobei der Grenzwert zwischen 5 Prozent und 25 Prozent liegt.

**9.** Verfahren nach mindestens einem der Ansprüche 1 bis 8, wobei die Strang-Leistungswerte verworfen werden, wenn eine Abweichung zwischen zwei zeitlich aufeinanderfolgenden Messwerten der Einstrahlung einen Grenzwert überschreitet, wobei der Grenzwert zwischen 100 Watt pro qm und 300 W pro qm liegt.

**10.** Verfahren nach mindestens einem der Ansprüche 1 bis 9, wobei die Strang-Leistungswerte verworfen werden, wenn eine Ausgangsleistung eines Inverters (5) des Strangs (3) begrenzt wurde.

**11.** Verfahren nach mindestens einem der Ansprüche 1 bis 10, wobei die gesamte Betriebszeit der PV-Module (2) betrachtet wird.

**12.** Verfahren nach mindestens einem der Ansprüche 1 bis 11, wobei der Verschmutzungsgrad (39) mindestens eines Strangs (3) ermittelt wird.

**Claims**

**1.** A method for detecting a degree of contamination of PV modules (2) of a string (3), comprising the following steps:

- determination of deviations (33) of the string power values (31) from a calculated reference value (30) over the last year;
- calculation of a historical trend line (34) from the deviations (33);
- determination of a maximum difference (35) between the trend line (34) and the deviations (33);
- calculation of final deviations (36) of the power values through subtraction of the maximum difference (35) from the trend line (34); and
- determination of the degree of contamination (39) through subtraction of the final deviations from the deviations.

**2.** The method according to claim 1, whereby the method is based on daily values.

**3.** The method according to claim 1 or 2, whereby an irradiation sensor is used for the calculation of the string power values.

**4.** The method according to claim 3, whereby a temporal offset of the string power values, brought about as a result of alignment errors of the irradiation sensor, is determined and considered.

**5.** The method according to claim 3 or 4, whereby measurement errors, brought about as a result of the ageing of the irradiation sensor, are determined through comparison of all previously observed cloud-free days and considered.

**6.** The method according to at least one of claims 1 to 5, whereby string power values from a time interval (17) around a maximum elevation angle of the sun are used.

**7.** The method according to at least one of claims 1 to 6, whereby the string power values are discarded if an output power of an inverter (5) of the string (3) exceeds a threshold value, whereby the threshold value is greater than 95 percent and lesser than 100 percent of a rated power output of the inverter (5).

**8.** The method according to at least one of claims 1 to 7, whereby the string power values are discarded if an average measured radiation deviates from a simulated radiation by a threshold value, whereby the threshold value falls between 5 percent and 25 percent.

**9.** The method according to at least one of claims 1 to 8, whereby the string power values are discarded if a deviation between two temporally successive measured radiation values exceeds a threshold value, whereby the threshold value falls between 100 Watts per square meter and 300 W per square meter.

**10.** The method according to at least one of claims 1 to 9, whereby the string power values are discarded if an output power of an inverter (5) of the string (3) has been limited.

**11.** The method according to at least one of claims 1 to 10, whereby the entire time of operation of the PV modules (2) is observed.

**12.** The method according to at least one of claims 1 to 11, whereby the degree of contamination (39) of at least one string (3) is determined.

**Revendications**

1. Procédé de détection du degré de salissure de panneaux PV (2) d'une ligne (3), comprenant les étapes suivantes :

   - la détermination des écarts (33) des valeurs de puissance de ligne (31) par rapport à une valeur de référence (30) calculée sur l'année passée ;
   - le calcul d'une courbe de tendance historique (34) à partir des écarts (33) ;
   - la détermination d'une différence maximale (35) entre la courbe de tendance (34) et les écarts (33) ;
   - le calcul d'écarts finaux (36) des valeurs de puissance par la soustraction de la différence maximale (35) de la courbe de tendance (34) ; et
   - la détermination du degré de salissure (39) par la soustraction des écarts finaux des écarts.

2. Procédé selon la revendication 1, dans lequel le procédé se base sur des valeurs quotidiennes.

3. Procédé selon la revendication 1 ou 2, dans lequel un capteur de rayonnement est utilisé pour le calcul des valeurs de puissance de ligne.

4. Procédé selon la revendication 3, dans lequel un décalage temporel des valeurs de puissance de ligne est déterminé par des erreurs d'alignement du capteur de rayonnement et pris en compte.

5. Procédé selon la revendication 3 ou 4, dans lequel une erreur de mesure due au vieillissement du capteur de rayonnement est déterminée par la comparaison de tous les jours sans nuages observés jusqu'à présent et prise en compte.

6. Procédé selon au moins l'une quelconque des revendications 1 à 5, dans lequel des valeurs de puissance de ligne provenant d'un intervalle de temps (17) autour de l'angle d'élévation maximal du soleil sont utilisées.

7. Procédé selon au moins l'une quelconque des revendications 1 à 6, dans lequel les valeurs de puissance de ligne sont rejetées lorsqu'une puissance de sortie d'un onduleur (5) de la ligne (3) dépasse une valeur limite, dans lequel la valeur limite est supérieure à 95 pour cent et inférieure à 100 pour cent d'une puissance de sortie nominale de l'onduleur (5).

8. Procédé selon au moins l'une quelconque des revendications 1 à 7, dans lequel les valeurs de puissance de ligne sont rejetées lorsqu'un rayonnement mesuré moyen varie d'une valeur limite par rapport à un rayonnement simulé, dans lequel la valeur limite se situe entre 5 pour cent et 25 pour cent.

9. Procédé selon au moins l'une quelconque des revendications 1 à 8, dans lequel les valeurs de puissance de ligne sont rejetées lorsqu'un écart entre deux valeurs de mesure du rayonnement qui se suivent dans le temps dépasse une valeur limite, dans lequel la valeur limite se situe entre 100 watts par mètre carré et 300 W par mètre carré.

10. Procédé selon au moins l'une quelconque des revendications 1 à 9, dans lequel les valeurs de puissance de ligne sont rejetées lorsqu'une puissance de sortie d'un onduleur (5) de la ligne (3) a été limitée.

11. Procédé selon au moins l'une quelconque des revendications 1 à 10, dans lequel le temps de fonctionnement total des panneaux PV (2) est pris en considération.

12. Procédé selon au moins l'une quelconque des revendications 1 à 11, dans lequel le degré de salissure (39) d'au moins une ligne (3) est déterminé.

Fig. 1

Fig. 2

Fig. 3

Fig. 4

Fig. 5

Fig. 6

Fig. 7

Fig. 8

Fig. 9

Fig. 10

Fig. 11

Fig. 12

Fig. 13

Fig. 14

Fig. 15

**IN DER BESCHREIBUNG AUFGEFÜHRTE DOKUMENTE**

*Diese Liste der vom Anmelder aufgeführten Dokumente wurde ausschließlich zur Information des Lesers aufgenommen und ist nicht Bestandteil des europäischen Patentdokumentes. Sie wurde mit größter Sorgfalt zusammengestellt; das EPA übernimmt jedoch keinerlei Haftung für etwaige Fehler oder Auslassungen.*

**In der Beschreibung aufgeführte Patentdokumente**

- US 2008272279 A1